# EUROPEAN PATENT SPECIFICATION

(11) **EP 1 911 083 B1**
(45) Date of publication and mention of the grant of the patent: **02.09.2020**
(21) Application number: 06786744.0
(22) Date of filing: 10.07.2006
(51) Int. Cl.: H01L 21/762

(54) **SEMICONDUCTOR CONSTRUCTIONS, MEMORY ARRAYS, ELECTRONIC SYSTEMS, AND METHODS OF FORMING SEMICONDUCTOR CONSTRUCTIONS**
HALBLEITERKONSTRUKTIONEN, SPEICHERARRAYS, ELEKTRONISCHE SYSTEME UND VERFAHREN ZUR BILDUNG VON HALBLEITERKONSTRUKTIONEN
STRUCTURES SEMI-CONDUCTRICES, MATRICES MEMOIRE, SYSTEMES ELECTRONIQUES ET PROCEDES POUR REALISER DES STRUCTURES SEMI-CONDUCTRICES

(30) Priority: 19.07.2005 US 185186
(43) Date of publication of application: 16.04.2008
(73) Proprietor: Micron Technology, Inc., Boise, ID 83707 (US)
(72) Inventor: SANDHU, Gurtej, S., Boise, ID 83706 (US); DURCAN, D. Mark, Boise, ID 83706 (US)
(74) Representative: Tunstall, Christopher Stephen
(86) International application number: PCT/US2006/026692
(87) International publication number: WO 2007/011566

(56) References cited:
- WO-A-85/03041
- FR-A- 2 826 179
- US-A- 4 472 240
- US-A- 6 150 212

## Description

### TECHNICAL FIELD

The invention pertains to semiconductor constructions, memory arrays, electronic systems, and methods of forming semiconductor constructions.

### BACKGROUND OF THE INVENTION

Trenched isolation regions (such as, for example, shallow trench isolation regions) are commonly utilized in integrated circuitry for electrically isolating electrical components from one another. The isolation regions extend into a semiconductor substrate, and comprise insulative material formed within trenches that have been etched into the substrate.

A problem that can occur during formation of trenched isolation regions is that voids can become trapped in the trenches during deposition of the insulative material within the trenches. The voids will have dielectric properties different than that of the insulative material, and accordingly will alter the insulative properties of the isolation regions. In response to this problem, numerous technologies have been developed for eliminating void formation within trenched isolation regions.

It is becoming increasingly difficult to eliminate void formation with increasing levels of integration. Specifically, trenched isolation regions are becoming narrower and deeper with increasing levels of integration, which renders it more difficult to uniformly fill the trenched isolation regions with insulative material.

In light of the above-discussed difficulties, it would be desirable to develop new methods for fabrication of trenched isolation regions which alleviate problems associated with voids. Although the invention described herein was motivated, at least in part, by the desire to alleviate problems associated with void formation in trenched isolation regions, persons of ordinary skill in the art will understand upon reading this disclosure and the claims thatfollow that aspects of the invention can have applications beyond trenched isolation regions.

US 4,472,240 describes a method for forming a groove in a semiconductor substrate. The groove may be buried with an insulating material or an electrode material.

US 6,150,212 describes a method for forming an isolation trench region in a semiconductor substrate.

WO 85/03041 describes a slot formation process in which the regions near the mouth of the slot are coated, while the slot is being formed, with a material which is resistant to the etchant being used to form the slot. During the formation of the middle and bottom regions of the slot the coated upper regions retain a nearly vertical contour shape. The coating material may be a thin oxide layer of the semiconductor material or may be a layer of an appropriate etch resistant material.

FR 2826179 describes a deep insulating trench in a semiconductor substrate with side walls and a base covered with an insulating material defining an empty cavity and forming a plug to seal this cavity.

### SUMMARY OF THE INVENTION

In one aspect, the invention includes a semiconductor construction. The construction comprises a semiconductor substrate and a trench extending into the substrate. The trench has a narrow bottom portion having a substantially vertical sidewall and an upper wide portion over the bottom portion and joining the bottom portion. A substantially solid electrically insulative material substantially fills the trench. The trench has a void within the substantially solid electrically insulative material. The upper wide portion joins the bottom portion at a plurality of steps that extend perpendicularly to the sidewall. The void is at least substantially entirely within the bottom portion of the trench.

In one aspect, the invention includes a memory array. The array comprises a plurality of transistors over a semiconductor substrate, with the transistors comprising gates and source/drain regions adjacent the gates. The array further comprises a plurality of charge storage devices electrically coupled with some of the source/drain regions. Additionally, the array comprises a plurality of isolation regions extending within the substrate and providing electrical isolation for at least some of the transistors. At least some of the individual isolation regions conform to the above described semiconductor construction.

In one aspect, the invention includes an electronic system. The system comprises a processor, and a memory device in data communication with the processor. At least one of the memory device and the processor includes one or more electrical isolation regions conforming to the above described semiconductor construction.

In one aspect, the invention includes a method of forming a semiconductor construction. A semiconductor substrate is provided, and a trench is formed extending into the substrate. In forming the trench, a first opening is formed to extend into the substrate. The first opening has a first width. A second opening is formed to extend downwardly into the substrate from the first opening. The second opening has a substantially vertical sidewall and a second width which is less than the first width. An electrically insulative material is formed within the first and second openings. The electrically insulative material substantially fills the first opening and leaves a void within the second opening. A plurality of steps that extend perpendicularly to the substantially vertical sidewall of the second opening are formed, such that the first opening joins the second opening at the plurality of steps. The void is at least substantially entirely within the second opening.

### BRIEF DESCRIPTION OF THE DRAWINGS

Preferred embodiments of the invention are described below with reference to the following accompanying drawings.
Fig. 1 is a diagrammatic, cross-sectional view of a semiconductor wafer fragment shown at a preliminary processing stage of an exemplary aspect of the present invention.
Fig. 2 is a top view of a portion of semiconductor construction comprising the cross-section of Fig. 1 along the line 1-1 of Fig. 2.
Fig. 3 is a view of the semiconductor wafer fragment of Fig. 1 shown at a processing stage subsequent to that of Fig. 1.
Fig. 4 is a view of the Fig. 1 wafer fragment shown at a processing stage subsequent to that of Fig. 3.
Fig. 5 is a view of the Fig. 1 wafer fragment shown at a processing stage subsequent to that of Fig. 4.
Fig. 6 is a top view of a portion of semiconductor construction comprising the cross-section of Fig. 5 along the line 5-5.
Fig. 7 is a diagrammatic, cross-sectional view of a semiconductor wafer fragment along the lines 7-7 of Figs. 5 and 6. The line 5-5 of Fig. 7 illustrates the location of the cross-section of Fig. 5.
Fig. 8 is a diagrammatic, cross-sectional view of a semiconductor wafer fragment illustrating an alternative aspect of the invention.
Fig. 9 is a diagrammatic, top view of a portion of a semiconductor construction comprising the cross-section of Fig. 8 along the line 8-8.
Fig. 10 is a diagrammatic, cross-sectional view along the lines 10-10 of Figs. 8 and 9. The line 8-8 of Fig. 10 illustrates the location of the cross-section of Fig. 8.
Fig. 11 is a diagrammatic, cross-sectional view of a semiconductor wafer fragment at a preliminary processing stage of an exemplary aspect of the present invention that can be utilized for forming the construction of Fig. 1.
Fig. 12 is a view of the Fig. 11 wafer fragment shown at a processing stage subsequent to that of Fig. 11.
Fig. 13 is a view of the Fig. 11 wafer fragment shown at a processing stage subsequent to that of Fig. 12.
Fig. 14 is a view of the Fig. 11 wafer fragment shown at a processing stage subsequent to that of Fig. 13.
Fig. 15 is a view of the Fig. 11 wafer fragment shown at a processing stage subsequent to that of Fig. 14.
Fig. 16 is a view of the Fig. 11 wafer fragment shown at a processing stage subsequent to that of Fig. 15.
Fig. 17 is a diagrammatic, cross-sectional view of a semiconductor wafer fragment at a processing stage similar to that of Fig. 3, and illustrating an example of the present disclosure.
Fig. 18 is a diagrammatic, cross-sectional view of a semiconductor wafer fragment at a processing stage similar to that of Fig. 1, and illustrating an alternative aspect of the invention.
Fig. 19 is a diagrammatic view of a computer illustrating an exemplary application of the present invention.
Fig. 20 is a block diagram showing particular features of the motherboard of the Fig. 19 computer.
Fig. 21 is a high-level block diagram of an electronic system according to an exemplary aspect of the present invention.
Fig. 22 is a simplified block diagram of an exemplary memory device according to an aspect of the present invention.

### DETAILED DESCRIPTION OF THE PREFERRED EMBODIMENTS

The invention includes trenched structures configured to trap voids in particular regions of the trenches. The voids can thus be uniformly and controllably incorporated into a plurality of trenched structures across a substrate. Accordingly, the invention includes aspects in which prior art problems associated with the voids are alleviated, not by eliminating the voids, but rather by developing structures which can control the locations of the voids.

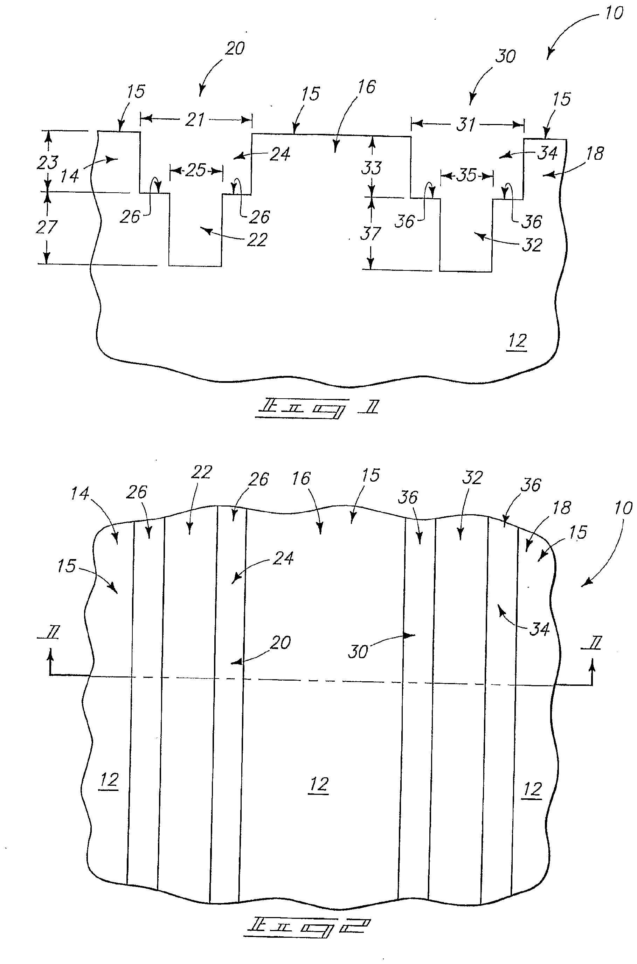

Exemplary aspects of the invention are described with reference to Figs. 1-22.

Referring to Figs. 1 and 2, a semiconductor fragment 10 illustrates trenches configured in accordance with an exemplary aspect of the present invention. The fragment 10 comprises a semiconductor substrate 12. In some aspects, such substrate can correspond to a bulk semiconductor material, such as, for example, bulk monocrystalline silicon of a monocrystalline silicon wafer. The monocrystalline silicon can be lightly-background doped with appropriate dopant such as, for example, p-type dopant. In some aspects, substrate 12 can comprise a semiconductor-on-insulator (SOI) substrate. In some aspects, substrate 12 can comprise a semiconductor material in combination with various layers of integrated circuitry (not shown) associated therewith.

To aid in interpretation of the claims that follow, the terms "semiconductive substrate" and "semiconductor substrate" are defined to mean any construction comprising semiconductive material, including, but not limited to, bulk semiconductive materials such as a semiconductive wafer (either alone or in assemblies comprising other materials thereon), and semiconductive material layers (either alone or in assemblies comprising other materials). The term "substrate" refers to any supporting structure, including, but not limited to, the semiconductive substrates described above.

A pair of trenches 20 and 30 extend into the substrate. Each of the trenches comprises a narrow bottom portion (22 of trench 20, and 32 of trench 30) joining to an upper wide portion (24 of trench 20, and 34 of trench 30) at steps (26 of trench 20, and 36 of trench 30).

The wide portions 24 and 34 comprise widths 21 and 31, respectively, and comprise depths 23 and 33, respectively. Similarly, the narrow portions 22 and 32 comprise widths 25 and 35, respectively, and comprise depths 27 and 37, respectively. The widths and depths of the wide portions 24 and 34 can be comparable to the widths and depths of conventional trenched isolation regions, and accordingly the widths can be from about 10 nanometers to about 100 nanometers; and the depths can be from about 50 nanometers to about 500 nanometers. In some aspects, the wide portions 24 and 34 will have relatively shallow depths, and accordingly the depths will be less than about 1 micrometre (micron), and in other aspects the wide portions 24 and 34 can be relatively deep and accordingly the depths will be at least about 1 micrometre (micron).

The narrow portions 22 and 32 will typically have widths that are from about one-third to about two-thirds of the widths of the corresponding wide portions, and generally will have widths that are about one-half of the width of the corresponding wide portions. The depths 27 and 37 can be any suitable depths, with typical depths being from about 50 nanometers to about 500 nanometers.

Substrate 12 comprises regions 14, 16 and 18 adjacent the trenches 20 and 30; with the region 16 being between the trenches 20 and 30. The substrate also comprises an upper surface 15 over the regions 14, 16 and 18.

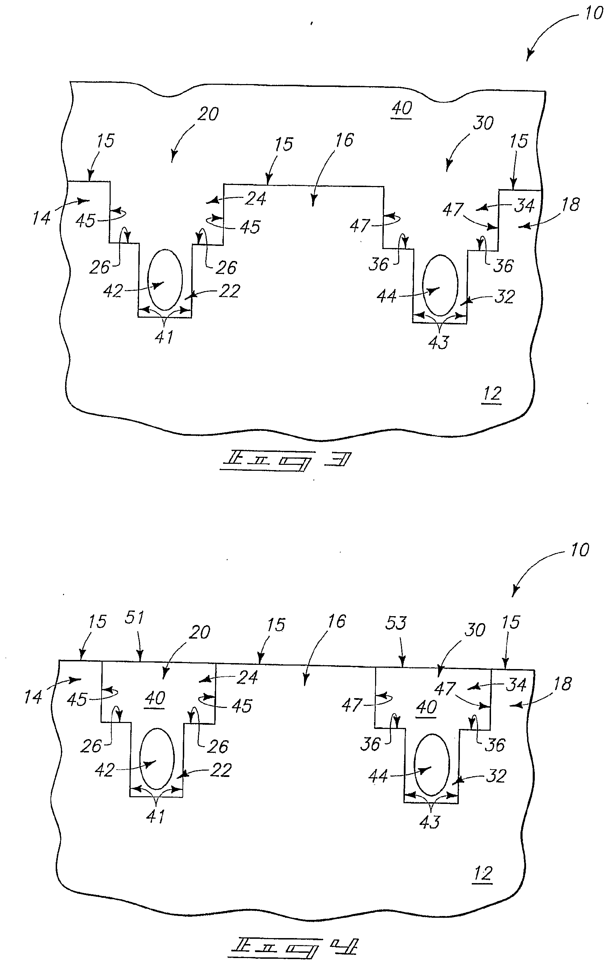

Referring next to Fig. 3, a substantially solid material 40 is deposited within openings 20 and 30. The material fills wide portions 24 and 34, but leaves voids 42 and 44 within the narrow portions 22 and 32, respectively. Material 40 is referred to as being a "substantially solid" material to indicate that the material can be, but is not limited to, pure solids, but instead can also comprise gelatinous materials and other semi-solid materials including, for example, various glasses. The material 40 can comprise any suitable composition or combination of compositions, and although shown to be substantially homogeneous, can comprise multiple layers. In particular aspects, material 40 is an electrically insulative material suitable for formation of trenched isolation regions. In such aspects the material can, for example, comprise, consist essentially of, or consist of silicon dioxide. For example, material 40 can be silicon dioxide formed by high density plasma (HDP) deposition.

The narrow portions 22 and 32 define locations where voids 42 and 44 will be formed within openings 20 and 30. Specifically, the voids will be at least substantially entirely retained within the narrow portions, with the term "substantially entirely retained within the narrow portions" meaning that the vast majority of the volume of a void is retained within a narrow portion. More specifically, such phrase means that at least about 75% of the volume of a void is retained within a narrow portion. In some aspects, the entirety of a void will be retained within the narrow portion of an opening. In other words, the entirety of the void will be at or below the elevational level of the steps which join the narrow portion to the wide portion (for example, the steps 26 and 36 of Fig. 3).

In the shown aspect of the invention, the narrow portions of the openings have substantially vertical sidewalls (41 for narrow portion 22, and 43 for narrow portion 32), and similarly the wide upper portions have substantially vertical sidewalls (45 for wide portion 24, and 47 for wide portion 34). The steps 26 and 36 extend substantially perpendicularly to the substantially vertical sidewalls, and in some aspects can extend exactly perpendicularly to the substantially vertical sidewalls.

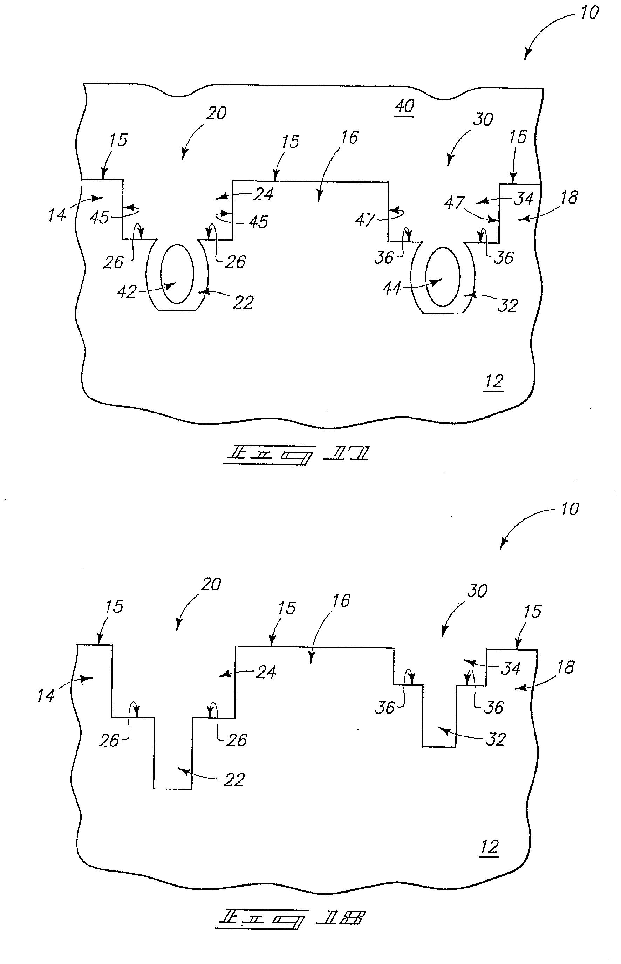

Utilization of perpendicularly-extending steps can provide clear delineation between the wide portions of the openings and the narrow portions of the openings, which can assist in forcing the voids to be retained substantially entirely within the narrow portions. In contrast, utilization of steps having a very gradual slope between the narrow portion of the opening and the wide portion of the opening can create difficulty in controlling the location of the voids within the trenches. It is to be understood, however, that any steps can be used which are suitable for delineating the narrow portions relative to the wide portions so that voids can be controllably retained within particular regions of trenches. Further, although, in an example of the present disclosure, the shown steps are only single steps between the wide portions of the openings and the narrow portions, it is to be understood that the invention encompasses aspects in which multiple steps are provided between the widest portion of an opening and the narrowest portion of an opening. In such aspects, the opening can still be considered to have "a" step between the wide portion and the narrow portion, but such step will be one of a plurality of steps between the wide portion and the narrow portion. The delineation between the wide portions of the openings and the narrow portions of the openings may be enhanced, in an example of the present disclosure, by curving the sidewalls of the narrow portions 22 and 32, as shown in Fig. 17.

Referring to Fig.4, material 40 is removed from over uppermost surfaces 15 of substrate 12. Such removal can be accomplished by, for example, chemical-mechanical polishing to form the shown planarized uppermost surfaces 51 and 53 of the material 40 across trenches 20 and 30, respectively. Such planarized uppermost surfaces are co-planar with the uppermost surface 15 of substrate 12.

If the material 40 within openings 20 and 30 is electrically insulative, such material can form trenched isolation regions within openings 20 and 30. In such aspects, the voids 42 and 44 can also be considered to be part of the trenched isolation regions. It can be advantageous to incorporate the voids into trenched isolation regions in that the voids will typically have very low dielectric constants, which can be desired for some applications of trenched isolation regions.

Voids 42 and 44 can contain any material which differs from the material 40. Thus, the term "void" is utilized to refer to regions devoid of material 40, but not necessarily devoid of other matter. The difference between the material of the voids and the material 40 can be, for example, differences in one or more of phase, density, and chemical composition. In some aspects of the invention, the voids 42 and 44 can be gaseous regions, and material 40 can be a non-gaseous material. If material 40 seals the voids from the atmosphere exterior of material 40, the particular gas within the voids can be the ambient present during deposition of material 40 at the processing stage of Fig. 3, and/or gases formed by out-gassing from material 40 during deposition of the material.

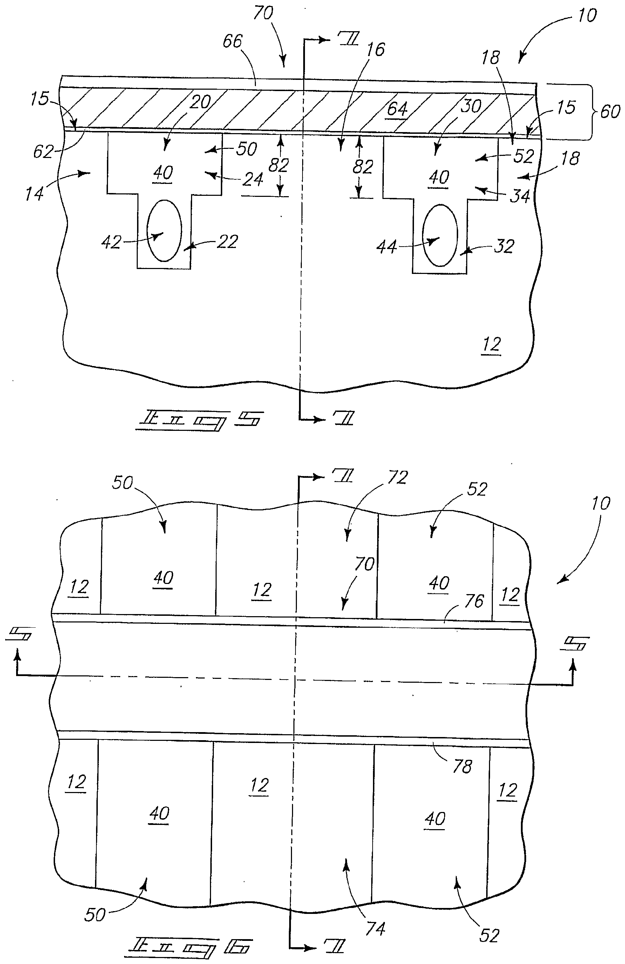

Referring to Figs. 5-7, the trenched isolation regions formed within openings 20 and 30 can be incorporated into an integrated circuit construction. In the application of Figs. 5-7, the trenched isolation region formed within opening 20 is shown as a first trenched isolation region 50, and the trenched isolation region formed within opening 30 is shown as a second trenched isolation region 52. A wordline 60 is shown formed across isolation regions 50 and 52, and a transistor device 70 is shown incorporating a portion of the wordline as a transistor gate.

The wordline 60 is shown in Fig. 5 to comprise a stack which includes dielectric material 62, conductive material 64, and an insulative cap 66. The dielectric material 62 can comprise any suitable gate dielectric, including, for example, silicon dioxide. In particular aspects, the dielectric material will comprise, consist essentially of, or consist of silicon dioxide. The conductive gate material 64 can comprise any suitable electrically conductive composition or combination of compositions; and in particular aspects will comprise, consist essentially of, or consist of one or more of conductively-doped semiconductor material (such as, conductively-doped silicon), metal (such as tungsten or titanium), and metal compounds (such as titanium silicide). The electrically insulative cap 66 can comprise any suitable composition or combination of compositions, and in particular aspects will comprise, consist essentially of, or consist of one or more of silicon dioxide, silicon nitride, and silicon oxynitride.

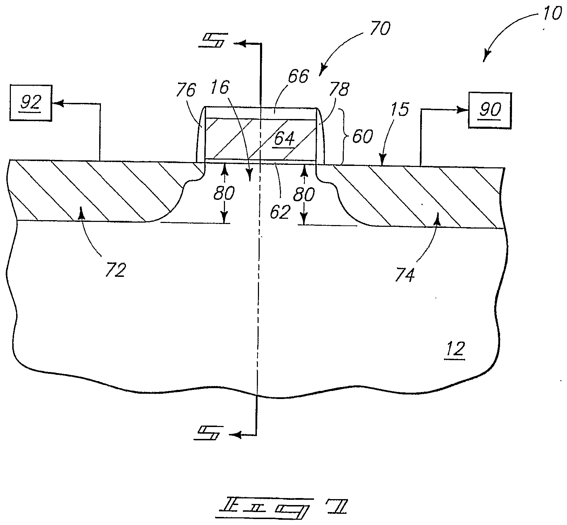

The wordline 60 extends across the trenched isolation regions 50 and 52, and also across the semiconductor substrate regions 14, 16 and 18 that are proximate the trenched isolation regions. The transistor construction 70 (which will be described in more detail below, and which is more clearly illustrated in Figs. 6 and 7) is over and within the region 16 of semiconductor substrate 12. Accordingly, the semiconductor material of substrate 12 that is within region 16 and directly below the wordline 60 can be doped with an appropriate threshold voltage implant, as such is a channel region of a transistor device.

Referring to Fig. 6, such shows a top view of a fragment comprising the cross-section of Fig. 5, and shows that the materials 62, 64 and 66 are patterned as a line extending across the substrate 12 and the isolation regions 50 and 52. Such also shows that the isolation regions 50 and 52 are trenches extending substantially orthogonally to the direction of the wordline 60.

Referring to Fig. 7, such shows a cross-section through the fragment of Fig. 6, and orthogonal to the cross-section discussed above with reference to Fig. 5. The cross-section of Fig. 7 shows that the transistor device 70 comprises source/drain regions 72 and 74 extending into the semiconductor substrate 12 on opposing sides of the wordline 60. The cross-section of Fig. 7 also shows that sidewall spacers 76 and 78 are formed along sidewalls of the stacked materials 62, 64 and 66. Such sidewall spacers can be conventional spacers as utilized in the art along sidewalls of wordlines, and can comprise, for example, one or more of silicon dioxide, silicon nitride and silicon oxynitride.

The source/drain regions 72 and 74 of Fig. 7 extend into substrate 12 to a depth 80; and the void regions 42 and 44 of Fig. 5 are retained at or below a depth 82 within substrate 12. In other words, the void regions 42 and 44 have uppermost surfaces that are beneath the surface 15 of substrate 12 by a depth 82 (Fig. 5), and the source/drain regions have lowermost surfaces that are at the depth 80 (Fig. 7) within substrate 12. In some aspects of the invention, the depths of the voids can be such that the voids are entirely beneath the elevational level of the source/drain regions within substrate 12. In other aspects, the source/drain regions elevationally overlap the voids within substrate 12. The voids can be considered an insulative material that is part of the isolation regions 50 and 52. In some aspects it can be advantageous for the source/drain regions to overlap such insulative material corresponding to the voids, and in other aspects it can be advantageous if the source/drain regions do not elevationally overlap such insulative material.

The transistor device 70 can be utilized in numerous applications, including, for example, in logic gates and memory cells. If the transistor device is utilized in memory cells, one of the source/drain regions 72 and 74 can be electrically coupled to a charge storage device, while the other is electrically coupled to a bitline. In the shown aspect of Fig. 7, the source/drain region 74 is shown coupled to a charge storage device 90, while the source/drain region 72 is shown electrically coupled to a bitline 92. The charge storage device can be, for example, a capacitor. As will be recognized by persons of ordinary skill in the art, the combination of a transistor with a capacitor can be considered to correspond to a dynamic random access memory (DRAM) cell. Accordingly, the transistor device 70 can be incorporated into a memory cell. In some aspects of the invention, a plurality of such memory cells can be formed across a semiconductor substrate to form a memory array.

The transistor structure of Figs. 5-7 is but one of many types of transistor structures that can be utilized in integrated circuitry. Other types of structures can include, for example, programmable read only memory (PROM) devices. PROM devices can utilize conductive gate material similar to the gate material 64 of Figs. 5-7, but utilize such material as a floating gate.

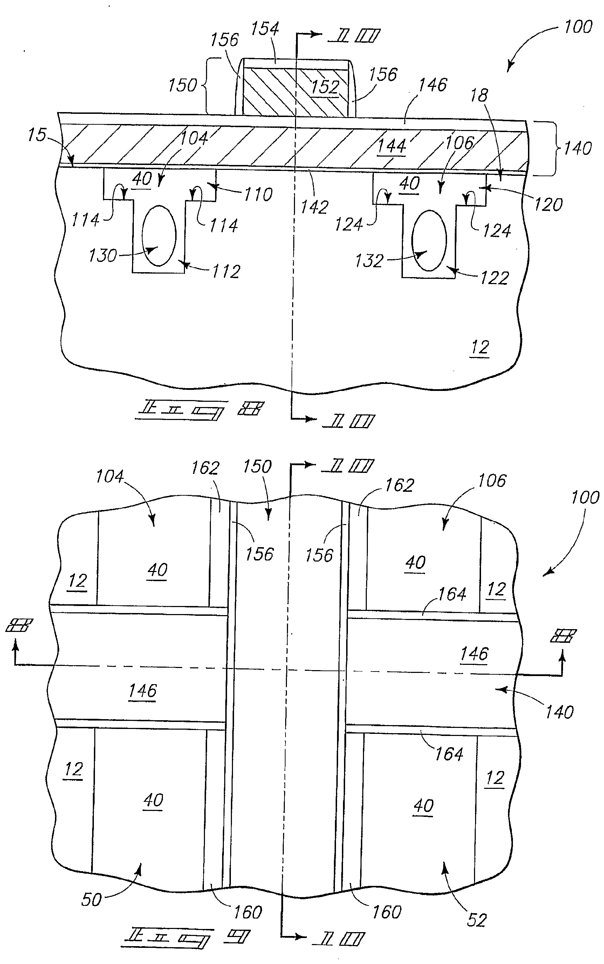

An exemplary PROM construction is described with reference to Figs. 8-10. In referring to Figs. 8-10, similar numbering will be used as was utilized above in describing Figs. 1-7, where appropriate.

Figs. 8-10 show a semiconductor construction 100 comprising a substrate 12 having isolation regions 104 and 106 extending therein. The isolation regions are trenched isolation regions. Such trenched isolation regions comprise wide upper portions (110 of isolation region 104, and 120 of isolation region 106) joined to narrow lower portions (112 of isolation region 104, and 122 of isolation region 106) through steps (114 of isolation region 104, and 124 of isolation region 106). The isolation regions also comprise voids 130 and 132 within the narrow portions 112 and 122, respectively.

The isolation regions 104 and 106 differ from the isolation regions 50 and 52 of Fig. 5 in that the wide portions 110 and 120 are significantly shallower than the wide portions 24 and 34, so that the voids 130 and 132 are less deep than the voids 42 and 44. The isolation regions 104 and 106 are shown differently in the construction of Figs. 8-10 than the isolation regions of Figs. 5-7 to illustrate a further exemplary aspect of the present invention for forming isolation regions, but not to indicate that there is any particular preference for the type of isolation regions of Figs. 8-10 for PROM devices relative to other transistor devices; or to indicate that there is any preference for the isolation regions of Figs. 5-8 for non-PROM devices.

Construction 100 comprises a floating gate stack 140 extending across substrate 12 and across isolation regions 104 and 106, and comprises a control gate stack 150 extending over the floating gate stack. In the shown aspect of the invention, the control gate stack extends orthogonally to the floating gate stack.

The floating gate stack comprises gate dielectric material 142, conductive material 144, and an insulative cap 146. The dielectric material 142 and conductive material 144 can comprise the same compositions as discussed above relative to materials 62 and 64 of wordline stack 60. The dielectric material 146 can comprise the same compositions as discussed above for material 66 of the wordline stack 60, but in some applications would be thinner than the material utilized for the wordline stack. At least material 146 would typically be relatively thin in the region where the floating gate stack is directly overlapped by the control gate stack 150 so that the control gate stack can be appropriately electrically coupled with the floating gate stack.

The control gate stack 150 comprises electrically conductive material 152 and an insulative cap 154. Also, sidewall spacers 156 are shown along sidewalls of the control gate stack.

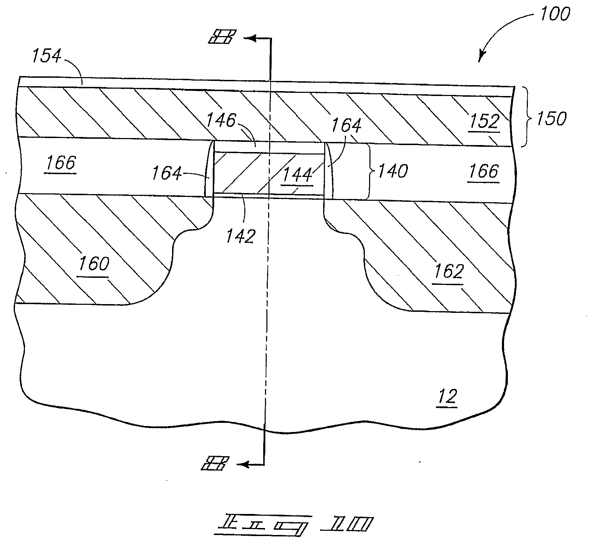

Fig. 10 shows a cross-section orthogonal to that of Fig. 8, and shows source/drain regions 160 and 162 extending into the substrate 12 proximate the floating gate stack 140. The cross-section also shows that sidewall spacers 164 are provided adjacent opposing sidewalls of the floating gate stack, and that insulative material 166 is provided adjacent the floating gate stack and utilized to support the wordline stack 150. The material 166 is not shown in the top view of Fig. 9 so that the relative locations of the isolation regions is visible in such top view, but it is to be understood that the insulative material 166 would typically extend laterally outward beyond the control gate 150.

The source/drain regions 160 and 162 are shown extending much deeper in the configuration of Fig. 10 than in the configuration of Fig. 7. Such is not to indicate any preference for the depth of the source/drain of a PROM device relative to a non-PROM device, but rather is to illustrate an aspect of the invention in which the source/drain regions extend deep enough to overlap with void regions (specifically, the void regions 130 and 132 of Fig. 8). Specifically, the combination of the relatively shallow void regions of Fig. 8 with the relatively deep source/drain regions 160 and 162 of Fig. 10 provides elevational overlap between the source/drain regions and the void regions within substrate 12.

The programmable transistor device of Fig. 10 can be incorporated into DRAM circuitry by electrically coupling one of the source/drain regions 160 and 162 to a charge storage device (such as, for example, a capacitor) and electrically coupling the other of the source/drain regions to a bitline. The PROM device can then be incorporated into a memory array (such as, for example, a flash memory array). The memory devices of a memory array can be substantially the same as one another. Thus, if a PROM device of Figs. 8-10 is utilized in a memory array, then the majority of the devices of such array can be PROM devices, (and in some aspects all of the devices of such memory array will be PROM devices). In contrast, if a non-PROM device of the type described with reference to Figs. 5-7 is utilized in a memory array, then the majority of the devices in the array can be non-PROM devices, (and in some aspects all of the devices within such memory array will be non-PROM devices).

Although the constructions discussed above show the first and second isolation regions to be the same shape as one another, it is to be understood that the invention also encompasses aspects in which the isolation regions differ from one another in shape. For instance, in some layouts the widths of the trenches can vary periodically. Such difference can be generated by, for example, utilizing different etching conditions to form some the trenches than are used to form others of the trenches. In some aspects, such different conditions can include different dry etch conditions. Fig. 18 shows a construction at a processing stage similar to that of Fig. 1, but in which the trench 20 is formed to be wider and deeper than the trench 30.

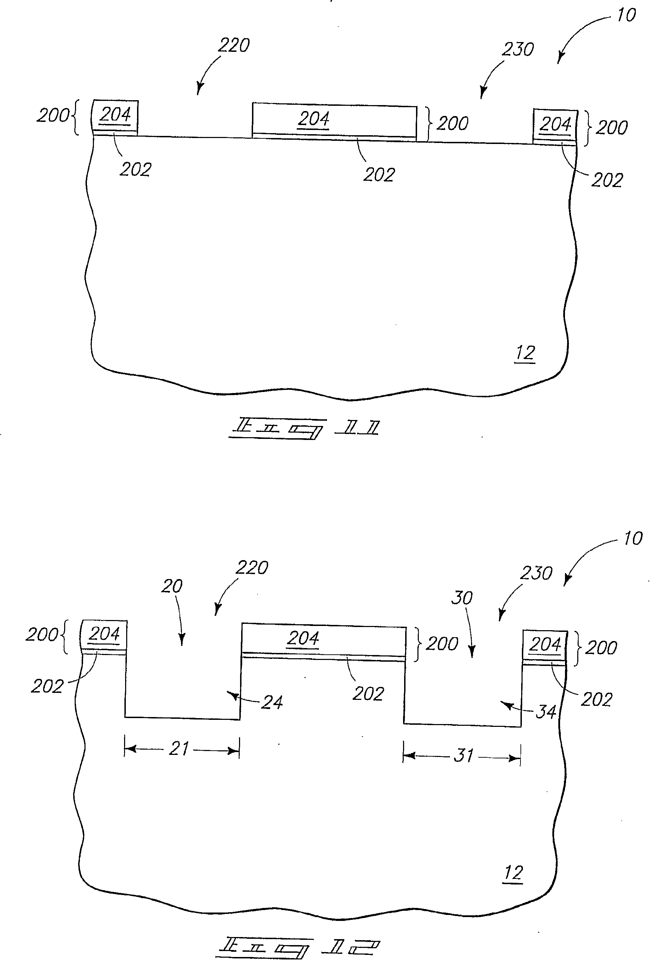

Figs. 11-16 describe an exemplary method which can be utilized for forming the trench structures of Fig. 1. It is to be understood that any suitable method can be utilized for forming the trenches of Fig. 1. The methodology of Figs. 11-16 is provided to assist the reader in understanding a method by which such structures can be formed, but is not to limit this application except to the extent, if any, that such method is expressly recited in the claims which follow. Similar numbering will be used In describing Figs. 11-16 as was utilized above in describing Figs. 1-7, where appropriate.

Referring to Fig. 11, wafer fragment 10 is illustrated at a preliminary processing stage. The wafer fragment comprises a patterned masking structure 200 over the semiconductor substrate 12. The patterned masking structure comprises a lower layer 202 and an upper layer 204. In particular aspects, the lower layer 202 can comprise pad oxide (specifically can comprise, consist essentially of, or consist of silicon dioxide) and the upper layer 204 can comprise, consist essentially of, or consist of silicon nitride.

The patterned structure 200 can be formed by any suitable processing. In particular aspects, layers 202 and 204 are formed to extend entirely across substrate 12, a layer of photoresist (not shown) is formed over the layers and photolithographically patterned, a pattern is transferred from the photoresist to the underlying layers 202 and 204, and the photoresist is then removed to leave the construction of Fig. 11.

The patterned structure 200 comprises openings 220 and 230 extending therethrough.

Referring to Fig. 12, openings 220 and 230 are extended into substrate 12 to form the widened portions 24 and 34 of openings 20 and 30. The openings 20 and 30 at the processing stage of Fig. 12 can be referred to as first openings extending into the substrate. Such openings have first widths 21 and 31.

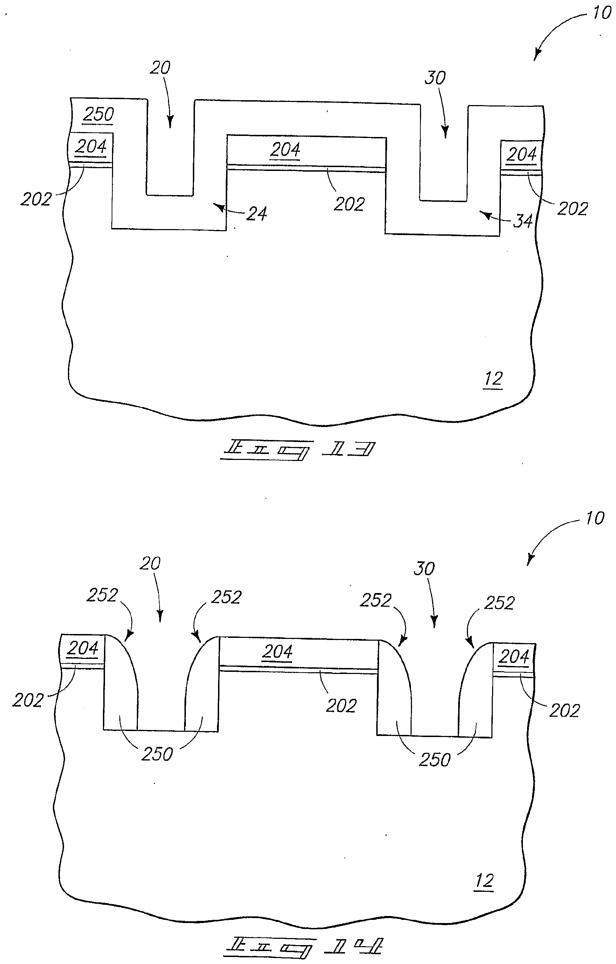

Referring to Fig. 13, a sacrificial masking material 250 is formed within openings 20 and 30 to partially fill the openings. Material 250 can comprise any suitable material, and preferably is a material which can be selectively etched relative to the underlying substrate 12. In particular aspects, material 250 can comprise, consist essentially of, or consist of one or both of silicon dioxide and silicon nitride.

Referring to Fig. 14, material 250 is anisotropically etched to form spacers 252 which narrow openings 20 and 30.

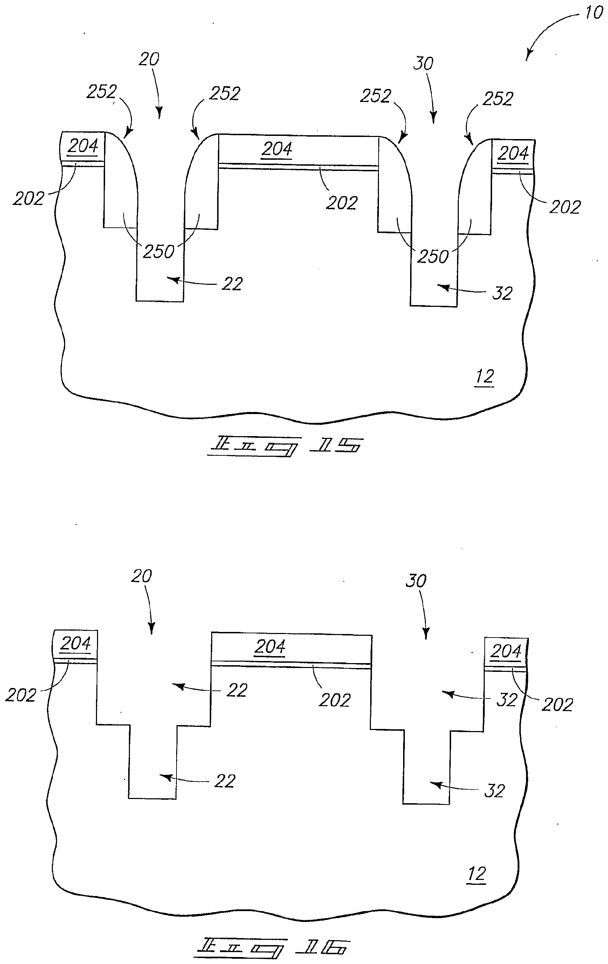

Referring to Fig. 15, substrate 12 is subjected to an etch while the material 250 is within openings 20 and 30. Such etch forms the narrow portions 22 and 32 extending into the substrate. The narrow portions 22 and 32 can be referred to as second openings which extend downwardly into the substrate from the first openings.

Referring to Fig. 16, masking material 250 is removed to leave a construction similar to that discussed above with reference to Fig. 1. The construction of Fig. 16 differs from that of Fig. 1 in that masking materials 202 and 204 are shown remaining in the construction of Fig. 16. Regardless, the construction of Fig. 16 can be treated identically to the treatment discussed above for Figs. 1-4. The masking materials 202 and 204 of the Fig. 16 construction can be removed by the CMP discussed above with reference to Fig. 4 to leave a construction identical to that shown in Fig. 4.

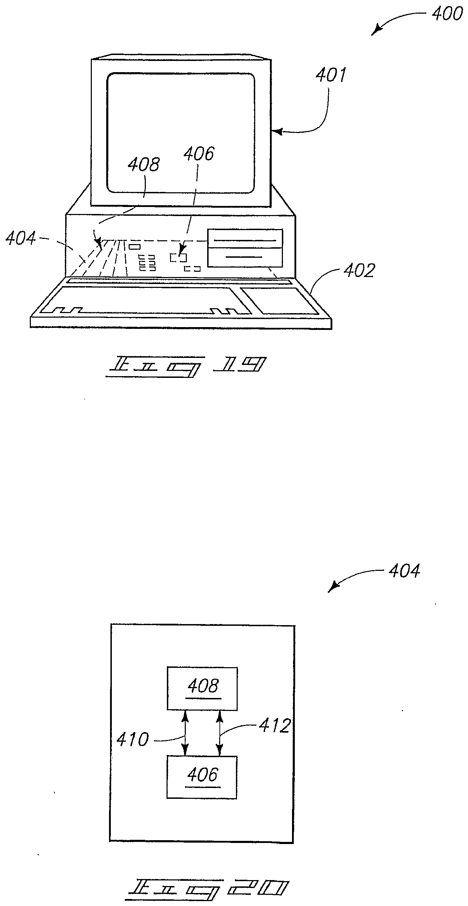

Fig. 19 illustrates generally, by way of example but not by way of limitation, an embodiment of a computer system 400 according to an aspect of the present invention. Computer system 400 includes a monitor 401 or other communication output device, a keyboard 402 or other communication input device, and a motherboard 404. Motherboard 404 can carry a microprocessor 406 or other data processing unit, and at least one memory device 408. Memory device 408 can comprise various aspects of the invention described above. Memory device 408 can comprise an array of memory cells, and such array can be coupled with addressing circuitry for accessing individual memory cells in the array. Further, the memory cell array can be coupled to a read circuit for reading data from the memory cells. The addressing and read circuitry can be utilized for conveying information between memory device 408 and processor 406. Such is illustrated in the block diagram of the motherboard 404 shown in Fig. 20. In such block diagram, the addressing circuitry is illustrated as 410 and the read circuitry is illustrated as 412. Various components of computer system 400, including processor 406, can comprise one or more of the memory constructions described previously in this disclosure.

Processor device 406 can correspond to a processor module, and associated memory utilized with the module can comprise teachings of the present invention.

Memory device 408 can correspond to a memory module. For example, single in-line memory modules (SIMMs) and dual in-line memory modules (DIMMs) may be used in the implementation which utilize the teachings of the present invention. The memory device can be incorporated into any of a variety of designs which provide different methods of reading from and writing to memory cells of the device. One such method is the page mode operation. Page mode operations in a DRAM are defined by the method of accessing a row of a memory cell arrays and randomly accessing different columns of the array. Data stored at the row and column intersection can be read and output while that column is accessed.

An alternate type of device is the extended data output (EDO) memory which allows data stored at a memory array address to be available as output after the addressed column has been closed. This memory can increase some communication speeds by allowing shorter access signals without reducing the time in which memory output data is available on a memory bus. Other alternative types of devices include SDRAM, DDR SDRAM, SLDRAM, VRAM and Direct RDRAM, as well as others such as SRAM or Flash memories.

Memory device 408 can comprise memory formed in accordance with one or more aspects of the present invention.

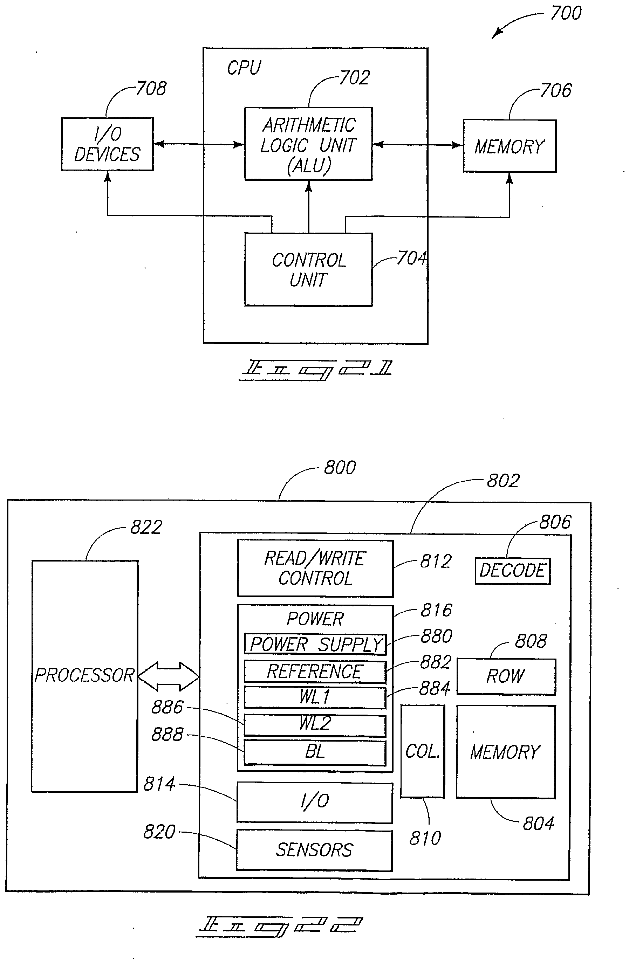

Fig. 21 illustrates a simplified block diagram of a high-level organization of various embodiments of an exemplary electronic system 700 of the present invention. System 700 can correspond to, for example, a computer system, a process control system, or any other system that employs a processor and associated memory. Electronic system 700 has functional elements, including a processor or arithmetic/logic unit (ALU) 702, a control unit 704, a memory device unit 706 and an input/output (I/O) device 708. Generally, electronic system 700 will have a native set of instructions that specify operations to be performed on data by the processor 702 and other interactions between the processor 702, the memory device unit 706 and the I/O devices 708. The control unit 704 coordinates all operations of the processor 702, the memory device 706 and the I/O devices 708 by continuously cycling through a set of operations that cause instructions to be fetched from the memory device 706 and executed. In various embodiments, the memory device 706 includes, but is not limited to, random access memory (RAM) devices, read-only memory (ROM) devices, and peripheral devices such as a floppy disk drive and a compact disk CD-ROM drive. One of ordinary skill in the art will understand, upon reading and comprehending this disclosure, that any of the illustrated electrical components are capable of being fabricated to include memory constructions in accordance with various aspects of the present invention.

Fig. 22 is a simplified block diagram of a high-level organization of various embodiments of an exemplary electronic system 800. The system 800 includes a memory device 802 that has an array of memory cells 804, address decoder 806, row access circuitry 808, column access circuitry 810, read/write control circuitry 812 for controlling operations, and input/output circuitry 814. The memory device 802 further includes power circuitry 816, and sensors 820, such as current sensors for determining whether a memory cell is in a low-threshold conducting state or in a high-threshold non-conducting state. The illustrated power circuitry 816 includes power supply circuitry 880, circuitry 882 for providing a reference voltage, circuitry 884 for providing the first wordline with pulses, circuitry 886 for providing the second wordline with pulses, and circuitry 888 for providing the bitline with pulses. The system 800 also includes a processor 822, or memory controller for memory accessing.

The memory device 802 receives control signals from the processor 822 over wiring or metallization lines. The memory device 802 is used to store data which is accessed via I/O lines. It will be appreciated by those skilled in the art that additional circuitry and control signals can be provided, and that the memory device 802 has been simplified to help focus on the invention. At least one of the processor 822 or memory device 802 can include a memory construction of the type described previously in this disclosure.

The various illustrated systems of this disclosure are intended to provide a general understanding of various applications for the circuitry and structures of the present invention, and are not intended to serve as a complete description of all the elements and features of an electronic system using memory cells in accordance with aspects of the present invention. One of the ordinary skill in the art will understand that the various electronic systems can be fabricated in single-package processing units, or even on a single semiconductor chip, in order to reduce the communication time between the processor and the memory device(s).

Applications for memory cells can include electronic systems for use in memory modules, device drivers, power modules, communication modems, processor modules, and application-specific modules, and may include multilayer, multichip modules. Such circuitry can further be a subcomponent of a variety of electronic systems, such as a clock, a television, a cell phone, a personal computer, an automobile, an industrial control system, an aircraft, and others.

## Claims

1. A semiconductor construction (10), comprising:
a semiconductor substrate (12);
a trench (20, 30) extending into the substrate; the trench comprising a narrow bottom portion (22, 32) having a substantially vertical sidewall and an upper wide portion (24, 34) over the bottom portion and joining the bottom portion; and
a substantially solid electrically insulative material (40) substantially filling the trench,
wherein the trench has a void (42, 44) within the substantially solid electrically insulative material, and **characterised by**:
the upper wide portion joining the bottom portion at a plurality of steps (26, 36) that extend perpendicularly to the sidewall; and
the void being at least substantially entirely within the bottom portion of the trench.

2. The construction of claim 1 wherein the upper portion is at least about twice as wide as the bottom portion.

3. The construction of claim 1 wherein the void (42, 44) is entirely within the bottom portion (22, 32) of the trench.

4. The construction of claim 1 wherein the electrically insulative material (40) comprises silicon dioxide.

5. The construction of claim 1 wherein the upper portion (24, 34) extends to a depth of at least about 1 micrometre within the substrate.

6. The construction of claim 1 wherein the upper portion (24, 34) extends to a depth that is less than about 1 micrometre within the substrate (12).

7. The construction of claim 1 wherein the electrically insulative material (40) is substantially homogeneous in composition throughout the upper wide portion (24, 34) and narrow bottom portion (22, 32).

8. The semiconductor construction of any of any preceding claim, further comprising a plurality of trenched regions, each trenched region comprising a said trench (20, 30).

9. The construction of claim 8 wherein said trenched regions are substantially the same shape as one another.

10. The construction of claim 8 wherein one or more of said trenched regions differ in shape relative to at least one other of said trenched regions.

11. The construction of claim 8 wherein said trenched regions are trenched isolation regions.

12. The construction of claim 11 further comprising transistor devices adjacent the isolation regions.

13. The construction of claim 12 wherein at least some of the transistor devices having source/drain regions that elevationally overlap the voids (42, 44).

14. The construction of claim 13 wherein the isolation regions comprise electrically insulative material (40) within the top and bottom portions.

15. A memory array (100), comprising:
a plurality of transistors over a semiconductor substrate, the transistors comprising gates and source/drain regions (160, 162) adjacent the gates;
a plurality of charge storage devices electrically coupled with some of the source/drain regions; and
a plurality of isolation regions extending within the substrate and providing electrical isolation for at least some of the transistors; at least some individual isolation regions conforming to the semiconductor construction of any preceding claim.

16. The memory array of claim 15 wherein at least a majority of the transistor gates of the memory array are floating gates of programmable memory devices.

17. The memory array of claim 15 wherein at least a majority of the transistor gates of the memory array are not floating gates of programmable memory devices.

18. The memory array of claim 15 wherein the charge storage devices are capacitors.

19. An electronic system, comprising:
a processor; and
a memory device in data communication with the processor; wherein:
at least one of the memory device and the processor includes one or more electrical isolation regions conforming to the semiconductor construction of any one of claims 1 to 14.

20. The electronic system of claim 19 further comprising transistors adjacent at least some of the electrical isolation regions.

21. The electronic system of claim 19 further comprising programmable memory devices adjacent at least some of the electrical isolation regions.

22. A method of forming a semiconductor construction, comprising:
providing a semiconductor substrate (12);
forming a trench extending into the substrate, wherein forming the trench comprises:
forming a first opening (24, 34) extending into the substrate, the first opening having a first width;
forming a second opening (22, 32) extending downwardly into the substrate from the first opening, the second opening having a substantially vertical sidewall and a second width which is less than the first width; and
forming electrically insulative material (40) within the first and second openings, the electrically insulative material substantially filling the first opening and leaving a void (42, 44) within the second opening, **characterised by**:
forming a plurality of steps that extend perpendicularly to the substantially vertical sidewall of the second opening, such that the first opening joins the second opening at the plurality of steps, and wherein
the void is at least substantially entirely within the second opening.

23. The method of claim 22 further comprising forming a masking material within the first opening (24, 34) to define a location for the second opening (22, 32), and wherein the second opening is formed while the masking material is within the first opening.

24. The method of claim 22 wherein the electrically insulative material (40) comprises silicon dioxide.

25. The method of claim 22 wherein the first opening (24, 34) is formed to a depth of at least about 1 micrometre within the substrate.

26. A method of forming a semiconductor construction, comprising:
performing the method of any one of claims 22 to 25; wherein the steps of forming the first and second openings (22, 24, 32, 34) are performed at first and second locations spaced from one another by a region of the semiconductor substrate (12); and
further comprising the step of:
forming a transistor having a gate over said region of the semiconductor substrate.

27. The method claim 26 wherein the transistor gate is floating gate, and further comprising forming a control gate over the floating gate.

## Patentansprüche

1. Halbleiterkonstruktion (10), umfassend:
ein Halbleitersubstrat (12);
einen Graben (20, 30), der sich in das Substrat erstreckt; der Graben umfassend einen schmalen unteren Abschnitt (22, 32) mit einer im Wesentlichen vertikalen Seitenwand und einen oberen breiten Abschnitt (24, 34) über dem unteren Abschnitt und in Verbindung mit dem unteren Abschnitt; und
ein im Wesentlichen festes elektrisch isolierendes Material (40), das den Graben im Wesentlichen füllt,
wobei der Graben einen Hohlraum (42, 44) innerhalb des im Wesentlichen festen elektrisch isolierenden Materials aufweist, und **gekennzeichnet durch**:
den oberen breiten Abschnitt, der an einer Mehrzahl von Stufen (26, 36) mit dem unteren Abschnitt in Verbindung steht, die sich senkrecht zu der Seitenwand erstrecken; und
den Hohlraum, der sich zumindest im Wesentlichen vollständig innerhalb des unteren Abschnitts des Grabens befindet.

2. Konstruktion nach Anspruch 1, wobei der obere Abschnitt zumindest ungefähr zweimal so breit wie der untere Abschnitt ist.

3. Konstruktion nach Anspruch 1, wobei sich der Hohlraum (42, 44) vollständig innerhalb des unteren Abschnitts (22, 32) des Grabens befindet.

4. Konstruktion nach Anspruch 1, wobei das elektrisch isolierende Material (40) Siliziumdioxid umfasst.

5. Konstruktion nach Anspruch 1, wobei sich der obere Abschnitt (24, 34) bis zu einer Tiefe von wenigstens ungefähr 1 Mikrometer innerhalb des Substrats erstreckt.

6. Konstruktion nach Anspruch 1, wobei sich der obere Abschnitt (24, 34) bis zu einer Tiefe erstreckt, die weniger als ungefähr 1 Mikrometer innerhalb des Substrats (12) beträgt.

7. Konstruktion nach Anspruch 1, wobei das elektrisch isolierende Material (40) in der Zusammensetzung im gesamten oberen breiten Abschnitt (24, 34) und schmalen unteren Abschnitt (22, 32) im Wesentlichen homogen ist.

8. Halbleiterkonstruktion nach einem der vorhergehenden Ansprüche, ferner umfassend eine Mehrzahl von Grabenbereichen, wobei jeder Grabenbereich einen der Gräben (20, 30) umfasst.

9. Konstruktion nach Anspruch 8, wobei die Grabenbereiche zueinander im Wesentlichen dieselbe Form aufweisen.

10. Konstruktion nach Anspruch 8, wobei sich einer oder mehrere der Grabenbereiche bezogen auf mindestens einen anderen der Grabenbereiche in der Form unterscheiden.

11. Konstruktion nach Anspruch 8, wobei die Grabenbereiche Graben-Isolationsbereiche sind.

12. Konstruktion nach Anspruch 11, ferner umfassend Transistorvorrichtungen angrenzend an die Isolationsbereiche.

13. Konstruktion nach Anspruch 12, wobei wenigstens einige der Transistorvorrichtungen Source/Drain-Bereiche aufweisen, die die Hohlräume (42, 44) höhenmäßig überlappen.

14. Konstruktion nach Anspruch 13, wobei die Isolationsbereiche elektrisch isolierendes Material (40) in den oberen und unteren Abschnitten umfassen.

15. Speicherarray (100), umfassend:
eine Mehrzahl von Transistoren über einem Halbleitersubstrat, die Transistoren umfassend Gates und Source/Drain-Bereiche (160, 162) angrenzend an die Gates;
eine Mehrzahl von Ladungsspeichervorrichtungen, die mit einigen der Source/Drain-Bereiche elektrisch gekoppelt sind; und
eine Mehrzahl von Isolationsbereichen, die sich innerhalb des Substrats erstrecken und elektrische Isolation für wenigstens einige der Transistoren bereitstellen; wobei wenigstens einige einzelne Isolationsbereiche der Halbleiterkonstruktion nach einem der vorhergehenden Ansprüche entsprechen.

16. Speicherarray nach Anspruch 15, wobei wenigstens eine Mehrzahl der Transistorgates des Speicherarrays schwebende Gates programmierbarer Speichervorrichtungen sind.

17. Speicherarray nach Anspruch 15, wobei wenigstens eine Mehrzahl der Transistorgates des Speicherarrays keine schwebenden Gates programmierbarer Speichervorrichtungen sind.

18. Speicherarray nach Anspruch 15, wobei die Ladungsspeichervorrichtungen Kondensatoren sind.

19. Elektronisches System, umfassend:
einen Prozessor; und
eine Speichervorrichtung in Datenkommunikation mit dem Prozessor; wobei:
mindestens eins von der Speichervorrichtung und dem Prozessor einen oder mehrere elektrische Isolationsbereiche aufweist, die der Halbleiterkonstruktion nach einem der Ansprüche 1 bis 14 entsprechen.

20. Elektronisches System nach Anspruch 19, ferner umfassend Transistoren angrenzend an wenigstens einige der elektrischen Isolationsbereiche.

21. Elektronisches System nach Anspruch 19, ferner umfassend programmierbare Speichervorrichtungen angrenzend an wenigstens einige der elektrischen Isolationsbereiche.

22. Verfahren zur Bildung einer Halbleiterkonstruktion, umfassend:
Bereitstellen eines Halbleitersubstrats (12);
Bilden eines Grabens, der sich in das Substrat erstreckt,
wobei Bilden des Grabens Folgendes umfasst:
Bilden einer ersten Öffnung (24, 34), die sich in das Substrat erstreckt, wobei die erste Öffnung eine erste Breite aufweist;
Bilden einer zweiten Öffnung (22, 32), die sich nach unten in das Substrat von der ersten Öffnung erstreckt,
wobei die zweite Öffnung eine im Wesentlichen vertikale Seitenwand und eine zweite Breite, die kleiner als die erste Breite ist, aufweist; und
Bilden elektrisch isolierenden Materials (40) innerhalb der ersten und zweiten Öffnung, wobei das elektrisch isolierende Material die erste Öffnung im Wesentlichen füllt und einen Hohlraum (42, 44) innerhalb der zweiten Öffnung hinterlässt, **gekennzeichnet durch**:
Bilden einer Mehrzahl von Stufen, die sich senkrecht zu der im Wesentlichen vertikalen Seitenwand der zweiten Öffnung erstrecken, so dass die erste Öffnung an der Mehrzahl von Stufen mit der zweiten Öffnung in Verbindung steht, und wobei
sich der Hohlraum zumindest im Wesentlichen vollständig innerhalb der zweiten Öffnung befindet.

23. Verfahren nach Anspruch 22, ferner umfassend Bilden eines Maskierungsmaterials innerhalb der ersten Öffnung (24, 34), um eine Stelle für die zweite Öffnung (22, 32) zu definieren, und wobei die zweite Öffnung gebildet wird, während sich das Maskierungsmaterial innerhalb der ersten Öffnung befindet.

24. Verfahren nach Anspruch 22, wobei das elektrisch isolierende Material (40) Siliziumdioxid umfasst.

25. Verfahren nach Anspruch 22, wobei die erste Öffnung (24, 34) bis zu einer Tiefe von wenigstens ungefähr 1 Mikrometer innerhalb des Substrats gebildet wird.

26. Verfahren zur Bildung einer Halbleiterkonstruktion, umfassend:
Durchführen des Verfahren nach einem der Ansprüche 22 bis 25, wobei die Schritte des Bildens der ersten und zweiten Öffnungen (22, 24, 32, 34) an ersten und zweiten Stellen durchgeführt werden, die um einen Bereich des Halbleitersubstrats (12) voneinander beabstandet sind;
und ferner umfassend den Schritt des:
Bildens eines Transistors mit einem Gate über dem Bereich des Halbleitersubstrats.

27. Verfahren nach Anspruch 26, wobei das Transistorgate ein schwebendes Gate ist, und ferner umfassend Bilden eines Steuergates über dem schwebenden Gate.

## Revendications

1. Construction semi-conductrice (10), comprenant :
un substrat semi-conducteur (12) ;
une tranchée (20, 30) s'étendant à l'intérieur du substrat, la tranchée comprenant une partie inférieure étroite (22, 32) ayant une paroi latérale sensiblement verticale, et une partie supérieure large (24, 34) par-dessus la partie inférieure et rejoignant la partie inférieure ; et
un matériau électriquement isolant sensiblement plein (40) remplissant en grande partie la tranchée,
dans laquelle la tranchée a un vide (42, 44) à l'intérieur du matériau électriquement isolant sensiblement plein, et **caractérisée en ce que** :
la partie supérieure large rejoint la partie inférieure au niveau d'une pluralité de marches (26, 36) qui s'étendent perpendiculairement à la paroi latérale ; et
le vide est au moins presque entièrement à l'intérieur de la partie inférieure de la tranchée.

2. Construction de la revendication 1, dans laquelle la partie supérieure est au moins environ deux fois plus large que la partie inférieure.

3. Construction de la revendication 1, dans laquelle le vide (42, 44) est entièrement à l'intérieur de la partie inférieure (22, 32) de la tranchée.

4. Construction de la revendication 1, dans laquelle le matériau électriquement isolant (40) comprend du dioxyde de silicium.

5. Construction de la revendication 1, dans laquelle la partie supérieure (24, 34) s'étend jusqu'à une profondeur d'au moins environ 1 micromètre à l'intérieur du substrat.

6. Construction de la revendication 1, dans laquelle la partie supérieure (24, 34) s'étend jusqu'à une profondeur qui est inférieure à environ 1 micromètre à l'intérieur du substrat (12).

7. Construction de la revendication 1, dans laquelle le matériau électriquement isolant (40) est sensiblement homogène en composition dans toute la partie supérieure large (24, 34) et la partie inférieure étroite (22, 32).

8. Construction semi-conductrice d'une quelconque revendication précédente, comprenant en outre une pluralité de régions en tranchée, chaque région en tranchée comprenant une dite tranchée (20, 30).

9. Construction de la revendication 8, dans laquelle lesdites régions en tranchée ont sensiblement la même forme les unes par rapport aux autres.

10. Construction de la revendication 8, dans laquelle une ou plusieurs desdites régions en tranchée ont une forme différente de celle d'au moins une autre desdites régions en tranchée.

11. Construction de la revendication 8, dans laquelle lesdites régions en tranchée sont des régions d'isolation en tranchée.

12. Construction de la revendication 11, comprenant en outre des dispositifs transistors adjacents aux régions d'isolation.

13. Construction de la revendication 12, dans laquelle au moins certains des dispositifs transistors ont des régions de source/drain qui en élévation chevauchent les vides (42, 44).

14. Construction de la revendication 13, dans laquelle les régions d'isolation comprennent un matériau électriquement isolant (40) à l'intérieur des parties supérieure et inférieure.

15. Matrice mémoire (100), comprenant :
une pluralité de transistors sur un substrat semi-conducteur, les transistors comprenant des grilles et des régions de source/drain (160, 162) adjacentes aux grilles ;
une pluralité de dispositifs de stockage de charge couplés électriquement à certaines des régions de source/drain ; et
une pluralité de régions d'isolation s'étendant à l'intérieur du substrat et fournissant une isolation électrique pour au moins certains des transistors ; au moins certaines régions d'isolation individuelles se conformant à la construction semi-conductrice d'une quelconque revendication précédente.

16. Matrice mémoire de la revendication 15, au moins une majorité des grilles de transistor de la matrice mémoire étant des grilles flottantes de dispositifs de mémoire programmable.

17. Matrice mémoire de la revendication 15, au moins une majorité des grilles de transistor de la matrice mémoire étant des grilles non flottantes de dispositifs de mémoire programmable.

18. Matrice mémoire de la revendication 15, dans laquelle les dispositifs de stockage de charge sont des condensateurs.

19. Système électronique, comprenant :
un processeur ; et
un dispositif de mémoire en communication de données avec le processeur ; dans lequel :
le dispositif de mémoire et/ou le processeur comportent une ou plusieurs régions d'isolation électrique se conformant à la construction semi-conductrice de l'une quelconque des revendications 1 à 14.

20. Système électronique de la revendication 19, comprenant en outre des transistors adjacents à au moins certaines des régions d'isolation électrique.

21. Système électronique de la revendication 19, comprenant en outre des dispositifs de mémoire programmable adjacents à au moins certaines des régions d'isolation électrique.

22. Procédé de formation d'une construction semi-conductrice, comprenant :
l'obtention d'un substrat semi-conducteur (12) ;
la formation d'une tranchée s'étendant à l'intérieur du substrat, la formation de la tranchée comprenant :
la formation d'une première ouverture (24, 34) s'étendant à l'intérieur du substrat, la première ouverture ayant une première largeur ;
la formation d'une deuxième ouverture (22, 32) s'étendant vers le bas à l'intérieur du substrat depuis la première ouverture, la deuxième ouverture ayant une paroi latérale sensiblement verticale et une deuxième largeur qui est inférieure à la première largeur ; et
la formation d'un matériau électriquement isolant (40) à l'intérieur des première et deuxième ouvertures, le matériau électriquement isolant remplissant en grande partie la première ouverture et laissant un vide (42, 44) à l'intérieur de la deuxième ouverture, **caractérisé par** :
la formation d'une pluralité de marches qui s'étendent perpendiculairement à la paroi latérale sensiblement verticale de la deuxième ouverture, de telle sorte que la première ouverture rejoint la deuxième ouverture au niveau de la pluralité de marches, et dans lequel
le vide est au moins presque entièrement à l'intérieur de la deuxième ouverture.

23. Procédé de la revendication 22, comprenant en outre la formation d'un matériau de masquage à l'intérieur de la première ouverture (24, 34) pour définir un emplacement pour la deuxième ouverture (22, 32), et dans lequel la deuxième ouverture est formée pendant que le matériau de masquage est à l'intérieur de la première ouverture.

24. Procédé de la revendication 22, dans lequel le matériau électriquement isolant (40) comprend du dioxyde de silicium.

25. Procédé de la revendication 22, dans lequel la première ouverture (24, 34) est formée jusqu'à une profondeur d'au moins environ 1 micromètre à l'intérieur du substrat.

26. Procédé de formation d'une construction semi-conductrice, comprenant :
la réalisation du procédé de l'une quelconque des revendications 22 à 25, dans lequel les étapes de formation des première et deuxième ouvertures (22, 24, 32, 34) sont réalisées à des premier et deuxième emplacements espacés l'un de l'autre par une région du substrat semi-conducteur (12) ; et comprenant en outre l'étape de :
formation d'un transistor ayant une grille par-dessus ladite région du substrat semi-conducteur.

27. Procédé de la revendication 26, dans lequel la grille de transistor est une grille flottante, et comprenant en outre la formation d'une grille de commande par-dessus la grille flottante.
